# EUROPÄISCHE PATENTSCHRIFT

(11) **EP 0 447 930 B1**
(45) Veröffentlichungstag und Bekanntmachung des Hinweises auf die Patenterteilung: **09.07.1997**
(21) Anmeldenummer: 91103783.6
(22) Anmeldetag: 13.03.1991
(51) Int. Cl.: G03F 7/032, G03F 7/029, G03F 7/11, C08F 2/50

(54) **Photopolymerisierbares Gemisch und daraus hergestelltes Aufzeichnungsmaterial**
Photopolymerisable composition and recording material produced therefrom
Composition photopolymérisable et matériau d'enregistrement ainsi produit

(30) Priorität: 20.03.1990 DE 4008815
(43) Veröffentlichungstag der Anmeldung: 25.09.1991
(73) Patentinhaber: Agfa-Gevaert AG, 51373 Leverkusen (DE)
(72) Erfinder: Zertani, Rudolf, Dr., W-6500 Mainz 43 (DE); Mohr, Dieter, Dr., W-6501 Budenheim (DE); Rode, Klaus, Dr., CEP-08600 Suzano-Sp (BR)

(56) Entgegenhaltungen:
- EP-A- 0 256 981
- EP-A- 0 269 573
- EP-A- 0 364 735
- EP-B- 0 119 162
- EP-B- 0 122 223
- DE-A- 3 839 394

## Beschreibung

Die Erfindung betrifft ein photopolymerisierbares Gemisch, das ein polymeres Bindemittel, eine polymerisierbare Verbindung, insbesondere einen Acryl- oder Alkacrylsäureester, sowie einen Photoinitiator enthält.

Es ist bekannt, daß man die radikalische Polymerisation von ethylenisch ungesättigten Verbindungen durch Bestrahlung mit sichtbarem Licht in Gegenwart von photoreduzierbaren Farbstoffen und Reduktionsmitteln, z.B. Aminen, anstoßen kann (US-A 3 097 096). Diese Initiatorkombinationen werden jedoch im wesentlichen nur in wäßriger Lösung oder in Kombination mit wasserlöslichen Bindemitteln eingesetzt. Initiatorkombinationen aus photoreduzierbaren Farbstoffen und anderen Reduktionsmitteln sind in den US-A 3 597 343 und 3 488 269 beschrieben.

In der EP-A 287 817 werden photopolymerisierbare Gemische beschrieben, die (Meth)acrylsäureester mit Urethangruppen und photooxydierbaren Gruppen, insbesondere tertiären Aminogruppen und ggf. Harnstoffgruppen im Molekül, polymere Bindemittel und, als Photoinitiatoren, eine Kombination aus einem photoreduzierbaren Farbstoff, einer strahlungsempfindlichen Trihalogenmethylverbindung und einer Acridin-, Phenazin- oder Chinoxalinverbindung enthalten.

In der EP-A 321 826 werden ähnliche Gemische mit (Meth)acrylsäureestern beschrieben, die keine Urethangruppen enthalten.

In der US-A 3 717 558 sind Metallocene von Elementen der Nebengruppen IIa bis VIIIa in Kombination mit einem weiteren Photoinitiator mit einer Carbonsäurechloridgruppe für den Einsatz in photopolymerisierbaren Aufzeichnungsmaterialien beschrieben. Diese Initiatorkombinationen sind sehr sauerstoff- und hydrolyseempfindlich und dadurch für die Herstellung von Druckplatten und Resistmaterialien weniger geeignet. Weitere Metallocene und deren Einsatz als Photoinitiatoren in photopolymerisierbaren Gemischen werden in den EP-A 119 162 und 122 223 beschrieben. Hierbei handelt es sich um Titanocene mit guter Stabilität gegen Luft, die eine spektrale Empfindlichkeit im Bereich vom UV-Licht bis zum sichtbaren Licht aufweisen. Sie enthalten als Liganden unter anderem Cyclopentadienylreste und fluorierte Phenylreste. Ferner werden in den EP-A 242 330 und 269 573 photopolymerisierbare Gemische beschrieben, die eine initiatormischung, bestehend aus einem Titanocen und einem flüssigen Photoinitiator vom Typ eines Hydroxy- oder Aminoacetophenons enthalten. Bei diesen Materialien ist die erzielbare Lichtempfindlichkeit für eine schnelle Bebilderung mit einem energieschwachen und zugleich kostengünstigen Argonionenlaser nicht ausreichend.

In der nicht vorveröffentlichten älteren EP-A-0 364 735 werden photopolymerisierbare Gemische beschrieben, die
- ein polymeres Bindemittel,
- eine radikalisch polymerisierbare Verbindung mit mindestens einer polymerisierbaren Gruppe,
- einen photoreduzierbaren Farbstoff,
- eine durch Strahlung spaltbare Trihalogenmethylverbindung und
- eine Metallocenverbindung, insbesondere ein Titanocen oder Zirkonocen,
enthalten. Als Vergleichsbeispiel 2 wird in dieser Anmeldung eine Kombination aus einem Terpolymerisat von Styrol, n-Hexylmethacrylat und Methacrylsäure mit der Säurezahl 190 als Bindemittel, Triethylenglykoldimethacrylat als polymerisierbare Verbindung und Dicyclopentadienyl-bis-pentafluorphenyl-titan als Photoinitiator beschrieben. In der nicht vorveröffentlichten älteren deutschen Patentanmeldung P 40 07 428.5 werden photopolymerisierbare Gemische der vorstehenden Zusammensetzung beschrieben, die als Metallocen ein Dicyclopentadienyl-bis-2,4,6-trifluor-phenyl-titan oder -zirkon enthalten.

Aufgabe der Erfindung war es, photopolymerisierbare Gemische vorzuschlagen, die sich zur Herstellung von Druckplatten hoher Auflagenleistung und Photoresists mit hoher Resistenz gegen Verarbeitungslösungen im gehärteten Zustand eignen, die sich durch eine hohe Lichtempfindlichkeit im nahen Ultraviolett- und im sichtbaren Spektralbereich bei einfacherer Zusammensetzung als die bekannten Gemische sowie durch eine gute thermische Lagerstabilität auszeichnen und die insbesondere zur Laserstrahlaufzeichnung im sichtbaren Bereich geeignet sind.

Erfindungsgemäß wird ein photopolymerisierbares Gemisch vorgeschlagen, das als wesentliche Bestandteile
a) ein polymeres Bindemittel,
b) eine radikalisch polymerisierbare Verbindung mit mindestens einer polymerisierbaren Gruppe und mindestens einer photooxydierbaren Gruppe im Molekül und
c) einen Photoinitiator
enthält.

Das erfindungsgemäße Gemisch ist dadurch gekennzeichnet, daß der Photoinitiator ein Metallocen ist. Ausgenommen ist, daß in dem Gemisch gleichzeitig a) ein Terpolymerisat von Styrol, n-Hexyl-methacrylat und Methacrylsäure mit der Säurezahl 190, b) ein Umsetzungsprodukt aus 1 mol Triethanolamin mit 3 mol Isocyanatoethyl-methacrylat und c) Dicyclopentadienyl-bis-pentafluorphenyltitan sein kann und daß das Gemisch zusätzlich eine Kombination aus einem photoreduzierbaren Farbstoff und einer durch Strahlung spaltbaren Trihalogenmethylverbindung enthält.

Die als Initiatoren eingesetzten Metallocene sind als solche und auch als Photoinitiatoren bekannt, z. B. aus den US-A 3 717 558, 4 590 287 und 4 707 432. Bevorzugt werden Metallocene von Elementen der IV. Nebengruppe des Periodensystems, insbesondere Verbindungen des Titans und Zirkons. Derartige Verbindungen sind in den EP-A 119 162, 122 223, 186 626, 242 330, 255 486, 256 981 und 269 573 beschrieben. Von den zahlreichen bekannten Metallocenen, insbesondere Titanocenen, werden Verbindungen der allgemeinen Formel I 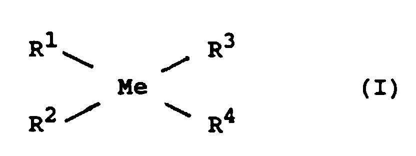 bevorzugt. In dieser Formel bedeuten
- Me: ein vierbindiges Metallatom, insbesondere Ti oder Zr,
- R¹ und R²: gleiche oder verschiedene Cyclopentadienylreste, die substituiert sein können, und
- R³ und R⁴: gleiche oder verschiedene Phenylreste, die auch substituiert sein können.

Die Cyclopentadienylgruppen können insbesondere durch Alkylreste mit 1 bis 4 Kohlenstoffatomen, Chloratome, Phenyl- oder Cyclohexylreste substituiert oder durch Alkylengruppen miteinander verknüpft sein. Sie sind bevorzugt unsubstituiert oder durch Alkylreste oder Chloratome substituiert.

R³ und R⁴ sind bevorzugt Phenylgruppen, die in o-Stellung zur Bindung mindestens ein Fluoratom enthalten und im übrigen durch Halogenatome, wie F, Cl oder Br, Alkyl- oder Alkoxygruppen mit 1 bis 4 Kohlenstoffatomen oder eine ggf. veretherte oder veresterte Polyoxyalkylengruppe substituiert sein können. Die Polyoxyalkylengruppe hat im allgemeinen 1 bis 6 Oxyalkyleneinheiten und steht bevorzugt in 4-Stellung des Phenylrests und kann durch einen Alkyl- oder Acylrest mit 1 bis 18 Kohlenstoffatomen verethert bzw. verestert sein; sie ist insbesondere eine Polyoxyethylengruppe. Phenylreste, die mit 4 oder 5 Fluoratomen substituiert sind, werden besonders bevorzugt.

Der Mengenanteil an Metallocenverbindung liegt im allgemeinen zwischen 0,01 und 10, vorzugsweise bei 0,05 bis 8 Gew.-%, bezogen auf die nichtflüchtigen Anteile des Gemischs.

Wenn eine Empfindlichkeitssteigerung des Gemischs im sichtbaren Spektralbereich erwünscht ist, kann diese durch Zusatz einer Verbindung vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Geeignete Vertreter dieser Verbindungen sind 4,4'-disubstituierte Dibenzalacetone, z.B. Diethylamino-4'-methoxy-dibenzalaceton, oder Cumarinderivate wie 3-Acetyl-7-diethylamino-, 3-Benzimidazolyl-7-diethylamino- oder Carbonyl-bis-(7-diethylaminocumarin). Die Menge dieser Verbindung liegt im Bereich von 0 bis 10, vorzugsweise von 0,05 bis 4 Gew.-%, bezogen auf die nichtflüchtigen Bestandteile des Gemischs.

Für die Zwecke der Erfindung geeignete polymerisierbare Verbindungen sind solche, die mindestens eine photooxydierbare und gegebenenfalls mindestens eine Urethangruppe im Molekül enthalten. Als photooxydierbare Gruppen kommen insbesondere Aminogruppen, Harnstoffgruppen, Thiogruppen, die auch Bestandteile heterocyclischer Ringe sein können, und Enolgruppen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Beispiele für Verbindungen mit photooxydierbaren Gruppen sind Acryl- und Alkacrylsäureester der Formel II 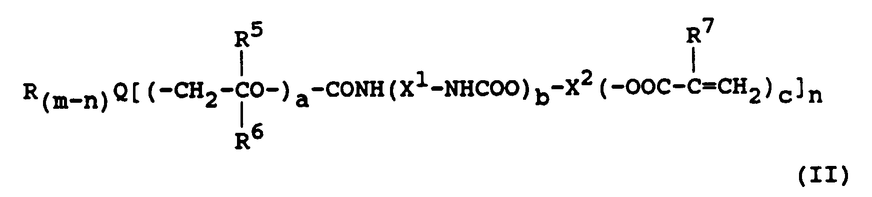 worin
- Q: 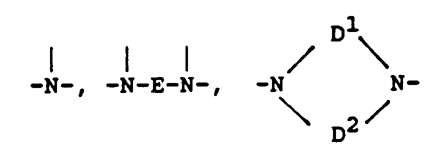 oder -S-
- R: eine Alkyl-, Hydroxyalkyl- oder Arylgruppe,
- R⁵ und R⁶: jeweils ein Wasserstoffatom, eine Alkylgruppe oder Alkoxyalkylgruppe,
- R⁷: ein Wasserstoffatom, eine Methyl- oder Ethylgruppe,
- X¹: eine gesättigte Kohlenwasserstoffgruppe mit 2 bis 12 Kohlenstoffatomen,
- X²: eine (c+1)-wertige gesättigte Kohlenwasserstoffgruppe, in der bis zu 5 Methylengruppen durch Sauerstoffatome ersetzt sein können,
- D¹ und D²: jeweils eine gesättigte Kohlenwasserstoffgruppe mit 1 bis 5 Kohlenstoffatomen,
- E: eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern,
- a: 0 oder eine Zahl von 1 bis 4,
- b: 0 oder 1,
- c: eine ganze Zahl von 1 bis 3,
- m: je nach Wertigkeit von Q 2, 3 oder 4 und
- n: eine ganze Zahl von 1 bis m
bedeutet, wobei alle Symbole gleicher Definition untereinander gleich oder verschieden sein können. Die Verbindungen dieser Formel, ihre Herstellung und Verwendung sind ausführlich in der EP-A 287 818 beschrieben. Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d.h. in denen m = n ist, werden im allgemeinen bevorzugt. Im allgemeinen ist in nicht mehr als einem, bevorzugt in keinem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatome substituiert sein.

Wenn R⁵ und R⁶ Alkyl- oder Alkoxyalkylgruppen sind, können diese 1 bis 5 Kohlenstoffatome enthalten. R⁷ ist bevorzugt ein Wasserstoffatom oder eine Methylgruppe, insbesondere eine Methylgruppe.

X¹ ist bevorzugt ein geradkettiger oder verzweigter aliphatischer oder cycloaliphatischer Rest mit vorzugsweise 4 bis 10 Kohlenstoffatomen.

X² hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12, vorzugsweise 2 bis 6 Kohlenstoffatomen eingesetzt. X² kann auch eine cycloaliphatische Gruppe mit 5 bis 10 Kohlenstoffatomen, insbesondere eine Cyclohexylengruppe sein. D¹ und D² können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt. Der Wert von c ist vorzugsweise 1.

Weitere geeignete Verbindungen mit photooxydierbaren Gruppen sind Verbindungen der Formel III 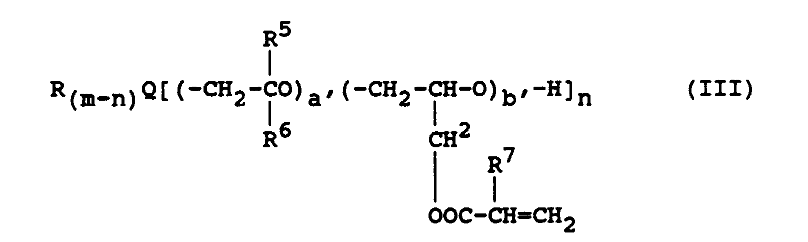 worin Q, R, R⁵, R⁶, R⁷, m und n die oben angegebene Bedeutung haben und Q zusätzlich eine Gruppe 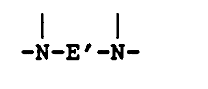 sein kann, worin E' eine Gruppe der Formel IV 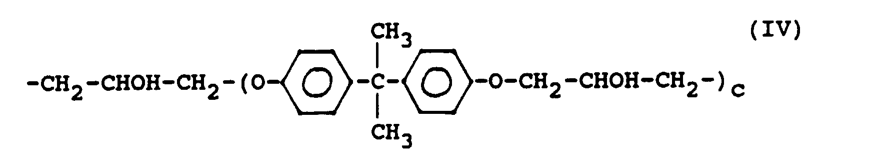 ist, in der c die Bedeutung wie in Formel II hat; a' und b' sind ganze Zahlen von 1 bis 4.

Die Verbindungen dieser Formel, ihre Herstellung und Verwendung sind ausführlich in der EP-A 316 706 beschrieben.

Weitere geeignete Verbindungen mit photooxydierbaren Gruppen sind Acryl- und Alkacrylsäureester der Formel V 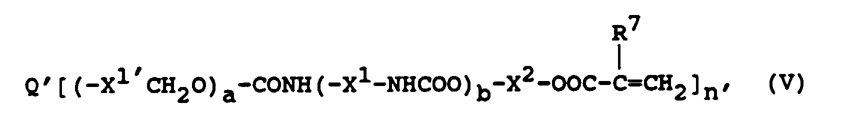 worin
- Q': 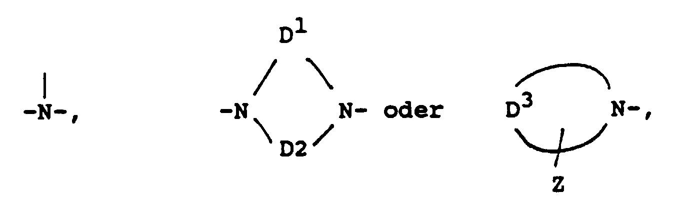
- X^{1'}: CᵢH₂ᵢ oder 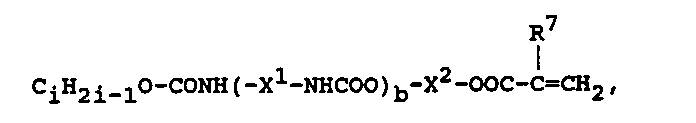
- D³: eine gesättigte Kohlenwasserstoffgruppe mit 4 bis 8 Kohlenstoffatomen, die mit dem Stickstoffatom einen 5- oder 6-gliedrigen Ring bildet,
- Z: ein Wasserstoffatom oder einen Rest der Formel 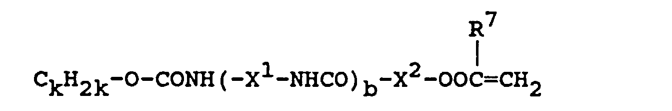
- i und k: ganze Zahlen von 1 bis 12,
- n': je nach Wertigkeit von Q' 1, 2 oder 3
bedeutet, und R⁷, X¹, X², D¹, D², a und b die bei Formel II angegebene Bedeutung haben, wobei alle Symbole gleicher Definition untereinander gleich oder verschieden sein können und wobei in mindestens einem Substituenten an der Gruppe Q' a = O ist.

Von den Verbindungen der Formel V werden solche bevorzugt, die außer einer Harnstoffgruppe mindestens eine Urethangruppe enthalten. Als Harnstoffgruppen sollen Gruppen der Formel

〉N - CO - N〈

angesehen werden, bei denen die Valenzen am Stickstoff mit ggf. substituierten Kohlenwasserstoffresten abgesättigt sind. Es kann aber auch eine Valenz an einem Stickstoffatom an eine weitere Carbonylamidgruppe (CONH) gebunden sein, so daß eine Biuretstruktur entsteht.

Das Symbol a ist in Formel V vorzugsweise 0 oder 1; i ist vorzugsweise eine Zahl von 2 bis 10.

Die polymerisierbaren Verbindungen der Formel V werden analog zu den Verbindungen der Formel II hergestellt. Die Verbindungen der Formel V und ihre Herstellung sind ausführlich in der EP-A 355 387 beschrieben.

Der Mengenanteil der photopolymerisierbaren Schicht an polymerisierbaren Verbindungen beträgt im allgemeinen etwa 10 bis 80, bevorzugt 20 bis 70 Gew.-%, bezogen auf die nichtflüchtigen Bestandteile.

Beispiele für verwendbare Bindemittel sind chloriertes Polyethylen, chloriertes Polypropylen, Poly(meth)acrylsäurealkylester, bei denen die Alkylgruppe z.B. Methyl, Ethyl, n-Butyl, i-Butyl, n-Hexyl oder 2-Ethylhexyl ist, Copolymere der genannten (Meth)-acrylsäurealkylester mit mindestens einem Monomeren, wie Acrylnitril, Vinylchlorid, Vinylidenchlorid, Styrol oder Butadien; Polyvinylchlorid, Vinylchlorid/Acrylnitril-Copolymere, Polyvinylidenchlorid, Vinylidenchlorid/Acrylnitril-Copolymere, Polyvinylacetat, Polyvinylalkohol, Polyacrylnitril, Acrylnitril/Styrol-Copolymere, Acrylnitril/Butadien/Styrol-Copolymere, Polystyrol, Polymethylstyrol, Polyamide (z.B. Nylon-6), Polyurethane, Methylcellulose, Ethylcellulose, Acetyl-cellulose, Polyvinylformal und Polyvinylbutyral.

Besonders geeignet sind Bindemittel, die in Wasser unlöslich, in organischen Lösemitteln löslich und in wässrig alkalischen Lösungen löslich oder zumindest quellbar sind.

Besonders erwähnt werden sollen Carboxylgruppen enthaltende Bindemittel, z.B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin geeignet sind Umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen insbesondere Formaldehyd, Acetaldehyd oder Aceton, mit Phenolen oder Copolymerisate der Hydroxystyrole. Schließlich lassen sich auch Copolymerisate des (Meth)acrylsäureamids mit Alkyl(meth)acrylaten verwenden.

Die vorstehend beschriebenen Polymeren sind insbesondere dann geeignet, wenn sie ein Molekulargewicht zwischen 500 und 200 000 oder darüber, bevorzugt 1000 bis 100 000 aufweisen und entweder Säurezahlen zwischen 10 und 250, bevorzugt von 20 bis 200, oder Hydroxylzahlen zwischen 50 und 750, bevorzugt von 100 bis 500, aufweisen.

Als bevorzugte alkalilösliche Bindemittel seien nachstehend erwähnt:

Copolymerisate der (Meth)acrylsäure mit Alkyl(meth)acrylaten, (Meth)acrylsäurenitril oder dergleichen, Copolymerisate der Crotonsäure mit Alkyl(meth)acrylaten, (Meth)acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäureanhydrids, Veresterungsprodukte von Hydroxylgruppen enthaltenden Polymeren mit Anhydriden von Di- oder Polycarbonsäuren, Copolymerisate der Hydroxyalkyl(meth)acrylate mit Alkyl(meth)acrylaten, (Meth)acrylsäurenitril oder dergleichen, Copolymerisate des Allylalkohols mit ggf. substituierten Styrolen, Copolymerisate des Vinylalkohols mit Alkyl(meth)acrylaten oder anderen polymerisationsfähigen ungesättigten Verbindungen, Polyurethane, sofern sie eine ausreichende Anzahl freier OH-Gruppen aufweisen, Epoxyharze, Polyester, teilverseifte Vinylacetat-Copolymere, Polyvinylacetale mit freien OH-Gruppen, Copolymerisate der Hydroxystyrole mit Alkyl(meth)acrylaten oder dergleichen, Phenol-Formaldehyd-Harze, z.B. Novolake. Die Menge des Bindemittels in der lichtempfindlichen Schicht beträgt im allgemeinen 20 bis 90, vorzugsweise 30 bis 80 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung. Die Lichtempfindlichkeit reicht von etwa 300 nm bis 700 nm und umspannt damit einen sehr breiten Bereich. Durch die Kombination von photooxydierbaren Monomeren und Metallocenen wird ein hochempfindliches photopolymerisierbares Gemisch erhalten, dessen Aktivität, besonders im langwelligen Spektralbereich bei oder oberhalb 455 nm, derjenigen von bekannten Gemischen überlegen ist.

Durch den Ersatz der Initiatorkombination aus photoreduzierbarem Farbstoff, Trihalogenmethylverbindung und Acridin-, Phenazin- oder Chinoxalinverbindung, die gemäß EP-A 287 817 in sonst gleichen photopolymerisierbaren Gemischen eingesetzt wird, werden Gemische mit höherer Lichtempfindlichkeit erhalten. Auch gegenüber Gemischen aus üblichen Monomeren und bekannten, Metallocene enthaltenden Initiatorkombinationen zeigen die erfindungsgemäßen Gemische eine erheblich höhere Lichtempfindlichkeit.

Als Anwendungsmöglichkeiten für das erfindungsgemäße Material seien genannt: Aufzeichnungsschichten für die photomechanische Herstellung von Druckformen für den Hochdruck, den Flachdruck, den Tiefdruck, den Siebdruck, von Reliefkopien, z.B. Herstellung von Texten in Blindenschrift, von Einzelkopien, Gerbbildern, Pigmentbildern usw. Weiter sind die Gemische zur photomechanischen Herstellung von Ätzreservagen, z. B. für die Fertigung von Namensschildern, von kopierten Schaltungen und für das Formteilätzen, anwendbar.

Besondere Bedeutung haben die erfindungsgemäßen Gemische als Aufzeichnungsschichten für die Herstellung von Flachdruckplatten und für die Photoresisttechnik. Als Schichtträger für das erfindungsgemäße Aufzeichnungsmaterial sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien erfolgt in bekannter Weise. So kann man die Schichtbestandteile in einem Lösemittel aufnehmen und die Lösung bzw. Dispersion durch Gießen, Sprühen, Tauchen, Antrag mit Walzen usw. auf den vorgesehenen Träger aufbringen und anschließend trocknen. Durch die breite spektrale Empfindlichkeit des erfindungsgemäßen Aufzeichnungsmaterials können alle dem Fachmann geläufigen Lichtquellen verwendet werden, z.B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Metallfadenlampe und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z.B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt.

Hierfür geeignete Materialien sind z. B. Polyvinylalkohol, Polyphosphate, Zucker usw. Solche Deckschichten haben im allgemeinen eine Dicke von 0,1 bis 10, vorzugsweise 1 bis 5 µm. Die weitere Verarbeitung der Materialien wird in bekannter Weise vorgenommen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche auf dem Träger zurückbleiben. Die Entwicklerlösungen können einen kleinen Anteil, vorzugsweise weniger als 5 Gew.-%, an mit Wasser mischbaren organischen Lösemitteln enthalten. Sie können ferner Netzmittel, Farbstoffe, Salze und andere Zusätze enthalten.

Bei der Entwicklung wird die gesamte Deckschicht zusammen mit den unbelichteten Bereichen der photopolymerisierbaren Schicht entfernt.

Im folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

### Beispiel 1 (Vergleichsbeispiel)

Als Schichtträger für Druckplatten wurde elektrochemisch aufgerauhtes und anodisiertes Aluminium mit einer Oxidschicht von 3 g/m² verwendet, das mit einer wäßrigen Lösung von Polyvinylphosphonsäure vorbehandelt worden war. Der Träger wurde mit einer Lösung der folgenden Zusammensetzung überzogen. Dabei wurden alle Operationen unter Rotlicht durchgeführt:

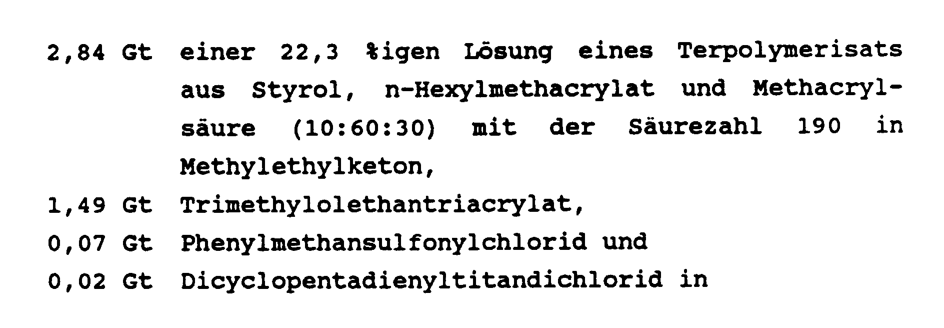

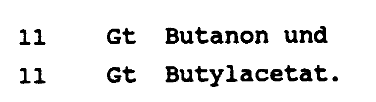

Das Auftragen erfolgte durch Aufschleudern in der Weise, daß ein Trockengewicht von 2,4 bis 2,8 g/m² erhalten wurde. Anschließend wurde die Platte zwei Minuten bei 100 ^{o}C im Umlufttrockenschrank getrocknet. Die Platte wurde dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 2,5 bis 4 g/m² erhalten. Die erhaltene Druckplatte wurde mittels einer 2 kW-Metallhalogenidlampe im Abstand von 110 cm 20 Sekunden unter unter einem 13-stufigen Belichtungskeil mit Dichteinkrementen von 0,15 belichtet. Um die Empfindlichkeit der Druckplatten im sichtbaren Licht zu testen, wurde auf den Belichtungskeil ein 3 mm starkes Kantenfilter der Firma Schott mit der Kantendurchlässigkeit von 455 nm montiert. Nach der Belichtung wurde die Platte eine Minute auf 100 ^{o}C erwärmt. Anschließend wurden sie mit einem Entwickler folgender Zusammensetzung entwickelt:

| | |
|---|---|
| 120 Gt | Natriummetasilikat x 9 H₂O, |
| 2,13 Gt | Strontiumchlorid, |
| 1,2 Gt | nichtionogenes Netzmittel (Kokosfettalkohol-Polyoxyethylenether mit ca. 8 Oxyethyleneinheiten) und |
| 0,12 Gt | Antischaummittel in |
| 4000 Gt | vollentsalztem Wasser. |

Die Platte wurde mit fetter Druckfarbe eingefärbt. Es wurden die in Tabelle 2 angegebenen vollvernetzten Keilstufen erhalten.

### Beispiele 2 bis 8

Auf den in Beispiel 1 angegebenen Schichtträger wurde unter gleichen Bedingungen wie dort eine Lösung folgender Zusammensetzung so aufgeschleudert, daß jeweils ein Schichtgewicht von 2,5 g/m² erhalten wurde:

| | |
|---|---|
| 2,84 Gt | der in Beispiel 1 angegebenen Terpoly merisatlösung, |
| 1,49 Gt | Monomeres gemäß Tabelle 1 und |
| 0,06 Gt | Dicyclopentadienyl-bis-pentafluorphenyltitan in |
| 22 Gt | Propylenglykolmonomethylether. |

Die Platte wurde dann wie in Beispiel 1 mit einer Polyvinylalkoholschicht überzogen und wie dort belichtet und entwickelt. Nach Einfärben mit fetter Druckfarbe wurden die in Tabelle 2 angegebenen vollvernetzten Keilstufen erhalten.

**Tabelle 1**

| Nr. | Eingesetzte Monomere |
|---|---|
| 1.) | Umsetzungsprodukt von 1 mol Triethanolamin mit 3 mol Isocyanatoethylmethacrylat, |
| 2.) | Umsetzungsprodukt von 1 mol N,N'-Bis-β-hydroxyethylpiperidin mit 2 mol Isocyanatoethylmethacrylat, |
| 3.) | Umsetzungsprodukt von 1 mol Triethanolamin mit 3 mol Glycidylmethacrylat, |
| 4.) | Umsetzungsprodukt von 1 mol Hexamethylendiisocyanat mit 1 mol 2-Hydroxy-ethylmethacrylat und 0,33 mol Triethanolamin, |
| 5.) | Trimethylolethantriacrylat, |
| 6.) | Umsetzungsprodukt von 1 mol Hexamethylendiisocyanat mit 0,5 mol 2-Hydroxy-ethylmethacrylat und 0,25 mol 2-Piperidin-ethanol, |
| 7.) | Pentaerythrittriacrylat. |

**Tabelle 2**

| Belichtungsergebnisse nach 20 Sekunden Belichtungszeit | | | |
|---|---|---|---|
| Beispiel | Monomer | Keilstufen | Keilstufen mit Kantenfilter |
| 2 | 1 | 10 - 11 | 8 - 9 |
| 3 | 2 | 9 | 7 - 8 |
| 4 | 3 | 7 - 9 | 8 |
| 5 | 4 | 7 - 9 | 8 |
| 6 (V) | 5 | 3 - 4 | 1 - 2 |
| 7 | 6 | > 13 | 11 - 13 |
| 8 (V) | 7 | 1 - 2 | * |
| | | | |
| 1 (V) | | 3 - 4 | 1 - 2 |

| | | | |
|---|---|---|---|
| * kein Bild V = Vergleichsbeispiel | | | |

### Beispiel 9

Die Beschichtungslösung aus Beispiel 7 wurde auf eine biaxial verstreckte 35 µm dicke Polyethylenterephthalatfolie so aufgeschleudert, daß nach dem Trocknen ein Schichtgewicht von 30 g/m² erhalten wurde. Die Schicht wurde drei Minuten bei 100 °C im Umlufttrockenschrank nachgetrocknet. Anschließend wurde die Schicht bei 115 °C mit 1,5 m je Minute auf einen gereinigten Träger laminiert, der aus einer Isolierstoffplatte mit 35 µm Kupferauflage bestand.

Die Schicht wurde mittels einer 5 kW-Metallhalogenidlampe (140 cm Abstand) unter einem Kantenfilter 455 nm, wie im Beispiel 1 beschrieben, mit einem Stufenkeil als Vorlage 30 Sekunden belichtet und nach dem Abziehen der Folie mit 0,8 %iger Sodalösung in einem Sprühprozessor 20 Sekunden entwickelt. Es wurden 4 vollvernetzte Keilstufen erhalten. Die vernetzte Schicht war gegen die in der Leiterplattentechnik übliche Eisen-III-chlorid-Lösung resistent. Die Ätzfestigkeit war gut.

### Beispiel 10

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m² erhalten wurde:

| | |
|---|---|
| 2,84 Gt | der in Beispiel 1 angegebenen Terpolymerisatlösung, |
| 1,49 Gt | Monomeres 6 gemäß Tabelle 1, |
| 0,01 Gt | Dicyclopentadienyl-bis-pentafluorphenyl-zirkon in |
| 11,0 Gt | Butanon und |
| 11,0 Gt | Butylacetat. |

Nach Auftragen einer Deckschicht aus Polyvinylalkohol wurde die Platte in gleicher Weise wie in Beispiel 1 20 Sekunden belichtet und dann entwickelt. Die Belichtung erfolgte unter einem Kantenfilter 455 nm. Es wurden 4 bis 5 vollvernetzte Keilstufen erhalten.

### Beispiel 11

Auf den in Beispiel 1 angegebenen Schichtträger wurden unter gleichen Bedingungen wie dort Lösungen folgender Zusammensetzung so aufgeschleudert, daß jeweils ein Schichtgewicht von 2,5 g/m² erhalten wurde:

| | |
|---|---|
| 2,84 Gt | der in Beispiel 1 angegebenen Terpolymerisatlösung, |
| 1,49 Gt | Monomeres 1 gemäß Tabelle 1, |
| 0,01 Gt | Dicyclopentadienyl-bis-2,4,6-trifluorphenyl-titan und |
| 22 Gt | Propylenglykolmonomethylether. |

Nach Auftragen einer Deckschicht aus Polyvinylalkohol wurden die Platten in gleicher Weise wie in Beispiel 1 10 Sekunden belichtet und dann entwickelt. Die Belichtung erfolgte unter einem 3 mm starken Kantenfilter mit der Kantendurchlässigkeit von 455 nm. Es wurden 8 - 9 vollvernetzte Keilstufen erhalten.

## Patentansprüche

1. Photopolymerisierbares Gemisch, das als wesentliche Bestandteile
a) ein polymeres Bindemittel
b) eine radikalisch polymerisierbare Verbindung mit mindestens einer polymerisierbaren Gruppe und mindestens einer photooxydierbaren Gruppe im Molekül und
c) einen Photoinitiator
enthält, dadurch gekennzeichnet, daß der Photoinitiator ein Metallocen ist,
mit der Maßgabe, daß in dem Gemisch nicht gleichzeitig a) ein Terpolymerisat von Styrol, n-Hexyl-methacrylat und Methacrylsäure mit der Säurezahl 190, b) ein Umsetzungsprodukt aus 1 mol Triethanolamin mit 3 mol Isocyanatoethyl-methacrylat und c) Di-cyclopentadienyl-bis-pentafluorphenyltitan ist, sowie der weiteren Maßgabe daß das Gemisch nicht zusätzlich eine Kombination aus einem photoreduzierbaren Farbstoff und einer durch Strahlung spaltbaren Trihalogenmethylverbindung enthält.

2. Gemisch nach Anspruch 1, dadurch gekennzeichnet, daß das Metallocen aus einem zentralen Metallatom und vier Liganden mit aromatischem Elektronensystem besteht.

3. Gemisch nach Anspruch 2, dadurch gekennzeichnet, daß das Metallatom ein Atom der IV. Nebengruppe des Periodensystems ist.

4. Gemisch nach Anspruch 3, dadurch gekennzeichnet, daß das Metallatom ein Titan- oder Zirkonatom ist.

5. Gemisch nach Anspruch 2, dadurch gekennzeichnet, daß zwei der Liganden ggf. substituierte Cyclopentadienylreste sind.

6. Gemisch nach Anspruch 2 oder 5, dadurch gekennzeichnet, daß zwei der Liganden Phenylreste sind, die ggf. durch Halogenatome oder Polyoxyalkylenreste substituiert sind.

7. Gemisch nach Anspruch 6, dadurch gekennzeichnet, daß die Halogenatome Fluoratome sind.

8. Gemisch nach Anspruch 1, dadurch gekennzeichnet, daß die radikalisch polymerisierbare Verbindung als photooxydierbare Gruppe eine Amino-, Harnstoff-, Thio- oder Enolgruppe enthält.

9. Gemisch nach Anspruch 1, dadurch gekennzeichnet, daß das Bindemittel wasserunlöslich und in wäßrig-alkalischen Lösungen löslich ist.

10. Gemisch nach Anspruch 1, dadurch gekennzeichnet, daß es 10 bis 80 Gew.-% polymerisierbare Verbindung, 20 bis 90 Gew.-% polymeres Bindemittel und 0,01 bis 10 Gew.-%, bezogen auf die nichtflüchtigen Bestandteile des Gemischs, an Metallocen enthält.

11. Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß Anspruch 1 besteht.

12. Aufzeichnungsmaterial nach Anspruch 11, dadurch gekennzeichnet, daß es auf der photopolymerisierbaren Schicht eine weitere, transparente, für Luftsauerstoff wenig durchlässige Schicht enthält, die in einer Entwicklerflüssigkeit für die photopolymerisierbare Schicht löslich ist.

## Claims

1. Photopolymerisable mixture, which contains as essential constituents
a) a polymerisable binder
b) a radically polymerisable compound containing at least one polymerisable group and at least one photooxidisable group in the molecule and
c) a photoinitiator,
characterised in that the photoinitiator is a metallocene,
with the proviso that the mixture does not simultaneously contain a) a terpolymer of styrene, n-hexyl methacrylate and methacrylic acid having the acid value 190, b) a reaction product of 1 mol of triethanolamine with 3 mol of isocyanatoethyl methacrylate and c) dicyclopentadienyl-bis-pentafluorophenyl titanium, and with the further proviso that the mixture does not additionally contain a combination of a photoreducible dye and a trihalomethyl compound capable of being split by radiation.

2. The mixture according to claim 1, characterised in that the metallocene consists of a central metal atom and four ligands having an aromatic electron system.

3. The mixture according to claim 2, characterised in that the metal atom is an atom of the fourth subgroup of the periodic system.

4. The mixture according to claim 3, characterised in that the metal atom is a titanium atom or zirconium atom.

5. The mixture according to claim 2, characterised in that two of the ligands are optionally substituted cyclopentadienyl groups.

6. The mixture according to claim 2 or 5, characterised in that two of the ligands are phenyl groups which are optionally substituted by halogen atoms or polyoxyalkylene groups.

7. The mixture according to claim 6, characterised in that the halogen atoms are fluorine atoms.

8. The mixture according to claim 1, characterised in that the radically polymerisable compound contains as the photooxidisable group an amino, urea, thio or enol group.

9. The mixture according to claim 1, characterised in that the binder is insoluble in water and soluble in aqueous alkaline solutions.

10. The mixture according to claim 1, characterised in that it contains 10 to 80 wt.% of polymerisable compound, 20 to 90 wt.% of polymeric binder and 0.01 to 10 wt.%, based on the non-volatile constituents of the mixture, of metallocene.

11. Photopolymerisable recording material containing a support and a photopolymerisable layer, characterised in that the photopolymerisable layer consists of a mixture according to claim 1.

12. Recording material according to claim 11, characterised in that it contains on the photopolymerisable layer an additional, transparent layer which is relatively impermeable to atmospheric oxygen and is soluble in a developer solution for the photopolymerisable layer.

## Revendications

1. Mélange photopolymérisable qui contient comme constituants essentiels
a) un liant polymérique,
b) un composé polymérisable par voie radicalaire ayant au moins un groupe polymérisable et au moins un groupe photooxydable dans la molécule et
c) un photoinitiateur,
caractérisé en ce que le photoinitiateur est un métallocène,
à condition qu'il n'y ait pas simultanément dans le mélange a) un terpolymère de styrène, de méthacrylate de n-hexyle et d'acide méthacrylique ayant un indice d'acide de 190, b) un produit de réaction de 1 mol de triéthanolamine avec 3 mol de méthacrylate d'isocyanatoéthyle et c) du dicyclopentadiényl-bis-pentafluorophényltitane, et à condition également que le mélange ne contienne pas en outre une combinaison d'un colorant photoréductible et d'un composé de trihalogénométhyle clivable par rayonnement.

2. Mélange selon la revendication 1 caractérisé en ce que le métallocène consiste en un atome métallique central et en 4 ligands ayant un système électronique aromatique.

3. Mélange selon la revendication 2 caractérisé en ce que l'atome métallique est un atome du quatrième sous-groupe du système périodique.

4. Mélange selon la revendication 3 caractérisé en ce que l'atome métallique est un atome de titane ou de zirconium.

5. Mélange selon la revendication 2 caractérisé en ce que deux des ligands sont des restes cyclopentadiényle éventuellement substitués.

6. Mélange selon la revendication 2 ou 5 caractérisé en ce que deux des ligands sont des restes phényle qui sont éventuellement substitués par des atomes d'halogène ou des restes polyoxyalkylène.

7. Mélange selon la revendication 6 caractérisé en ce que les atomes d'halogène sont des atomes de fluor.

8. Mélange selon la revendication 1 caractérisé en ce que le composé polymérisable par voie radicalaire contient comme groupe photooxydable un groupe amino, urée, thio ou énol.

9. Mélange selon la revendication 1 caractérisé en ce que le liant est insoluble dans l'eau et soluble dans les solutions alcalines aqueuses.

10. Mélange selon la revendication 1 caractérisé en ce qu'il contient 10 à 80 % en masse de composé polymérisable, 20 à 90 % en masse de liant polymérique et 0,01 à 10 % en masse, par rapport aux constituants non volatils du mélange, de métallocène.

11. Matériau d'enregistrement photopolymérisable ayant un support de couche et une couche photopolymérisable, caractérisé en ce que la couche photopolymérisable consiste en un mélange selon la revendication 1.

12. Matériau d'enregistrement selon la revendication 11 caractérisé en ce qu'il contient sur la couche photopolymérisable une autre couche, transparente, peu perméable à l'oxygène de l'air, qui est soluble dans un liquide de développement pour la couche photopolymérisable.
